# EUROPÄISCHE PATENTSCHRIFT

(11) **EP 1 213 189 B1**
(45) Veröffentlichungstag und Bekanntmachung des Hinweises auf die Patenterteilung: **13.10.2004**
(21) Anmeldenummer: 01128673.9
(22) Anmeldetag: 01.12.2001
(51) Int. Cl.: B60R 16/02

(54) **Einrichtung zur Überwachung eines Bordnetzes eines Fahrzeuges**
Device for monitoring a vehicle power supply network
Dispositif pour surveiller le réseau de bord d'un véhicule

(30) Priorität: 06.12.2000 DE 10060490
(43) Veröffentlichungstag der Anmeldung: 12.06.2002
(73) Patentinhaber: Hella KG Hueck & Co., 59552 Lippstadt (DE)
(72) Erfinder: Fuisting, Manfred, 48231 Warendorf (DE); Rosenmayer, Marc, Dr., 59555 Lippstadt (DE)

(56) Entgegenhaltungen:
- EP-A- 1 046 545
- DE-A- 3 942 167
- GB-A- 2 072 966
- US-A- 3 995 210
- US-A- 4 518 913
- US-A- 5 467 008

## Beschreibung

Die Erfindung bezieht sich auf eine Einrichtung zur Überwachung eines Bordnetzes eines Fahrzeuges mit einem Sensor zur Messung von in einer Anschlussleitung fließendem elektrischen Strom, gemäß dem Oberbegrift von Anspruch 1.

Eine derartige Einrichtung für die Überwachung eines Kraftfahrzeug-Bordnetzes ist aus der DE 197 36 025 A1 bekannt. Die dort beschriebene Einrichtung weist einen Sensor zur Messung des Stroms in der Anschlussleitung einer Batterie des Bordnetzes auf. Über den Stromsensor kann der von der Batterie zu den Verbrauchern (Starter, Lampen, Radio etc.) abfließende Strom sowie der der Batterie über den Generator zugeführte Ladestrom gemessen werden. In Verbindung mit einer Zeitdauermessung kann so die der Batterie entnommene und die zugeführte elektrische Ladung bestimmt werden. Mit Hilfe von weiteren Informationen wie Temperatur und Batteriespannung lässt sich insgesamt der Ladezustand der Batterie gut bestimmen. Aufgrund der Tatsache, dass immer mehr elektrische Verbraucher in einem Fahrzeug eingesetzt und immer mehr Funktionen elektrisch bzw. elektromechanisch realisiert werden, gewinnt die Bordnetzüberwachung und damit die Überprüfung des Batterieladezustandes als Teil der Bordnetzüberwachung immer mehr an Bedeutung. Die Kenntnis des Batterieladezustandes ist insbesondere dann notwendig, wenn sicherheitsrelevante Einrichtungen, wie zum Beispiel eine elektromechanischen Bremse, beim Ausfall des Generators allein über die Batterie versorgt werden müssen. In diesem Fall muss der Fahrer rechtzeitig gewarnt werden, falls die Batterie eine bestimmte Ladezustandsschwelle unterschritten hat.

Um den Ladezustand der Batterie mit Hilfe der Strommessung möglichst genau bestimmen zu können, ist es erforderlich, nicht nur große und mittlere Ströme messen zu können, sondern auch kleine Ströme, da auch Verbraucher mit einer kleinen Stromaufnahme bei einer langen Einschaltdauer eine beträchtliche Verringerung der Batteriekapazität bewirken.

Aufgabe der Erfindung ist es daher, eine Einrichtung zur Überwachung eines Bordnetzes eines Fahrzeuges zu schaffen, bei der in zuverlässiger und einfacher Weise eine Messung des in einer Anschlussleitung zur Batterie fließenden Stroms über einen großen Messbereich (mehrere Dekaden) möglich ist.

Diese Aufgabe wird erfindungsgemäß dadurch gelöst, dass mindestens zwei Sensoren zur Messung des Stroms in der Anschlussleitung vorgesehen sind, deren Messbereiche voneinander verschieden sind, wobei wenigstens einer der beiden Sensoren für eine potentialfreie Messung des Stroms ausgebildet ist. Potentialfreie Messung bedeutet hierbei ohne galvanischen Kontakt zur Anschlussleitung. Dabei wird für diesen Zweck vorzugsweise ein Magnetfeldsensor (Hallsensor oder magnetoresistiver Sensor) eingesetzt, der zur Messung des Stroms das von diesem erzeugte Magnetfeld misst.

Durch das Vorsehen von zwei Sensoren mit unterschiedlichen Messbereichen wird insgesamt ein größerer Messbereich abgedeckt. Dadurch, dass mindestens einer der beiden Sensoren als potentialfrei messender Sensor ausgebildet ist, wird - wie weiter unten näher erläutert wird - einerseits die Zuverlässigkeit der Einrichtung erhöht und andererseits eine einfache und kostengünstige Messbereichsumschaltung bzw. eine einfache und kostengünstige Auswahl des für den jeweils aktuellen Messbereich relevanten Sensors ermöglicht.

In vorteilhafter Weise ist es vorgesehen, dass die Messbereiche der beiden Sensoren sich in einem Teilbereich überlappen. In diesem Fall werden im Überlappungsbereich von beiden Sensoren Messwerte aufgenommen, die einer beiden Sensoren gemeinsamen Auswerteeinheit zugeführt werden. Dabei wird anhand der Messwerte des ersten Sensors eine Eichung des zweiten Sensors durchgeführt oder umgekehrt. Diese Eichung wird in der gemeinsamen Auswerteeinheit durchgeführt. Dabei bedeutet Eichung die Kalibrierung von Parametern, Koeffizienten, Verstärkungsfaktoren oder dergleichen, die bei der Auswertung der von dem zu eichenden Sensor gemessenen Signale von der Auswerteeinheit herangezogen werden. Eichung im Rahmen der Erfindung ist jedoch auch die elektronische Einstellung von Parametern am Sensor selbst durch die Auswerteeinheit, die dann auch als Steuereinheit ausgebildet ist. Dabei wird vorzugsweise einer der beiden Sensoren als vorab vom Werk bei Auslieferung der Einrichtung absolut geeichter Sensor eingesetzt. Dieser Sensor eicht dann, wie vorstehend beschrieben, nach dem Einbau der Einrichtung in das Fahrzeug den anderen Sensor durch Vergleich der im Messwert-Überlappungsbereich gemessenen Werte.

In einer ersten Ausführungsform sind beide Sensoren zur potentialfreien Messung des Stroms ausgebildet, wobei bevorzugt zwei Magnetfeldsensoren eingesetzt werden.

In einer zweiten Ausführungsform der Erfindung ist ein Magnetfeldsensor für die Messung der kleinen Ströme vorgesehen, während zur Messung der großen Ströme ein in der Anschlussleitung angeordneter Widerstand (Shunt) als Sensor vorgesehen, wobei der Spannungsabfall, den der zu messende Strom an diesem Widerstand hervorruft, gemessen wird. In einer besonders kostengünstigen Variante dieser Ausführungsform bildet ein Teil der Anschlussleitung selbst den Messwiderstand aus. Diese Ausführungsform stellt also eine Kombination aus einem Sensor, der galvanisch potentialmäßig mit der Anschlussleitung verbunden ist, und einem potentialfreien Sensor dar.

Ein potentialfrei messender Sensor hat den Vorteil, dass dieser durch Spannungs- oder Stromspitzen auf der stromführenden Anschlussleitung nicht beschädigt wird. Im umgekehrten Fall hat die Verwendung eines galvanisch nicht im Strompfad der Anschlussleitung eingebundenen Sensors den Vorteil, dass auch bei einer Beschädigung des Sensors der Strom weiterhin ungehindert in der Anschlussleitung fließen kann. Außerdem beeinflusst ein potentialfrei messender Stromsensor das Spannungspotential des Bordnetzes im Unterschied zu einem in der Anschlussleitung angeordneten Messwiderstand nicht.

Im Unterschied zu einer Strommesseinrichtung, die aus zwei in der Anschlussleitung parallel oder seriell angeordneten Messwiderständen besteht, zwischen denen zur Messbereichsumschaltung durch ein Schaltelement umgeschaltet wird, ist die Messbereichsumschaltung bei Verwendung von wenigstens einem potentialfrei messenden Stromsensor wesentlich einfacher und kostengünstiger zu realisieren. Bei Verwendung eines oder zweier potentialfreier Sensoren können beide Sensoren gleichzeitig, unabhängig voneinander und ohne sich gegenseitig zu beeinflussen den Strom messen. Dabei wird von der Auswerteeinheit lediglich detektiert, welches der beiden Sensorsignale seinen jeweiligen Messbereich über- oder unterschritten hat, wobei das jeweils andere Sensorsignal, das innerhalb seines vorherbestimmten Messbereich liegt, als Signal für die Strommessung ausgewertet wird. Ein Schaltelement zur Messbereichsumschaltung ist nicht notwendig. Dadurch, dass eine galvanische Umschaltung zwischen einem ersten Messwiderstand und einem zweiten Messwiderstand entfällt, gibt es auch keine störende Änderung im Spannungspotential für die Verbraucher des Bordnetzes, die im Falle einer Messbereichsumschaltung zwischen zwei Widerständen auftreten würde.

Es ist besonders vorteilhaft, die erfindungsgemäße Einrichtung einer Anschlussleitung der Batterie zuzuordnen, da so in einfacher Weise sämtliche Ströme erfast werden. Es ist jedoch genauso möglich, mit der erfindungsgemäßen Einrichtung die Ströme in anderen Strompfaden zu messen.

Anhand der beigefügten Zeichnungen soll die Erfindung nachfolgend näher erläutert werden. Es zeigt:
- Figur 1: eine schematische Darstellung eines Bordnetzes mit den zwei Magnetfeldsensoren,
- Figur 2: die Anordnung der beide Magnetfeldsensoren im Magnetfeld, das von dem zu messenden Strom erzeugt wird,
- Figur 3: eine schematische Darstellung eines Bordnetzes mit einem Magnetfeldsensor und einem Messwiderstand,
- Figur 4: eine Einrichtung mit einem Magnetfeldsensor und einem Messwiderstand, der Teil der stromführenden Anschlussleitung ist,
- Figur 5: eine Darstellung der beiden Messbereiche mit dem Überlappungsbereich,
- Figur 6: eine schematische Darstellung des Sensorgehäuses, in dem der stromführende Anschlussleiter verläuft und die Sensoren angeordnet sind.

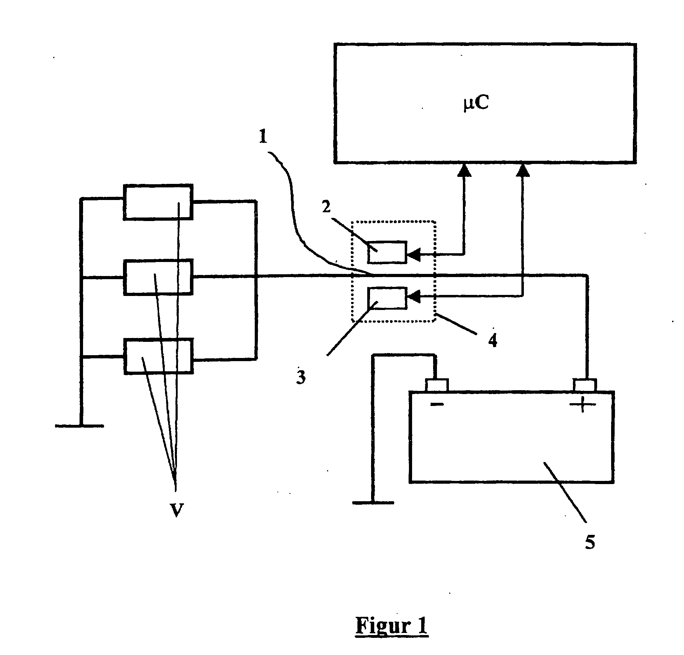

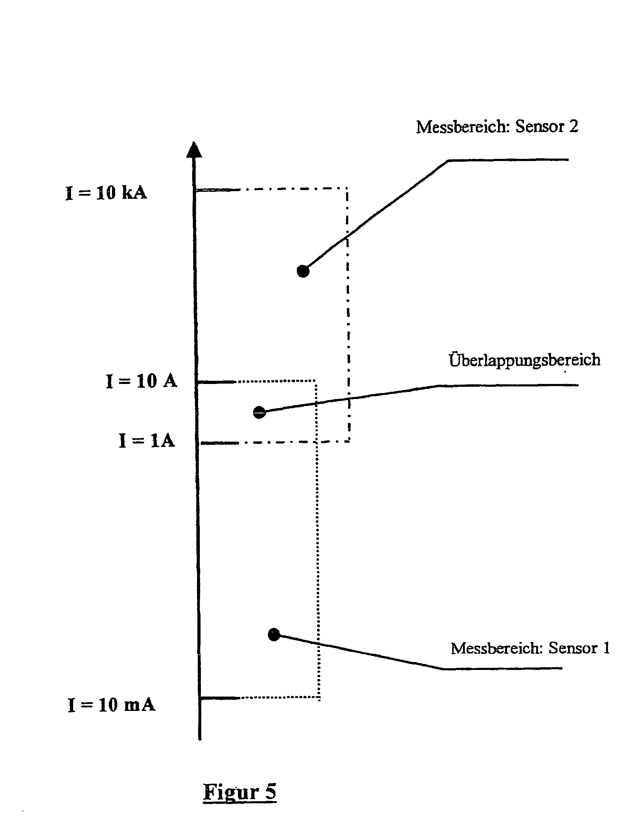

Figur 1 zeigt eine schematische Darstellung eines Bordnetzes, das eine Batterie (5) aufweist, über die die verschiedensten Verbraucher (V) im Fahrzeug mit Strom versorgt werden. Der Minuspol der Batterie (5) ist mit Masse (Fahrzeugkarosserie) verbunden. Der Pluspol ist über eine Anschlussleitung (1) mit den Verbrauchern (V) und dem Generator (nicht dargestellt) verbunden. Über diese Anschlussleitung (1) fließen sämtliche Ströme von der Batterie (5) bzw. zur Batterie. Dieser Anschlussleitung (1) sind nun zwei Sensoren (2, 3) mit unterschiedlichen Messbereichen zur Strommessung zugeordnet. Selbstverständlich können die Sensoren auch der Anschlussleitung, welche von dem Minuspol der Batterie (5) zur Karosseriemasse führt, zugeordnet sein. In der Ausführungsform gemäß Figur 1 sind beide Sensoren (2, 3) als Magnetfeldsensoren ausgebildet, die zur Messung des Stroms in der Anschlussleitung (1) das von dem Strom erzeugte Magnetfeld messen. Dabei ist einer der Sensoren (2) ein Hallsensor und der andere ein magnetoresistiver Sensor (3). Als Hallsensor kann beispielsweise der Sensorbaustein HAL 400/401 der Fa. Micronas Intermetall eingesetzt werden. Als magnetoresistiver Sensor kann der Sensorbaustein KMZ10 der Fa. Philips eingesetzt werden. Die Empfindlichkeit und der Messbereich der Magnetfeldsensoren (2, 3) hängt neben sensorspezifischen Parametern (z.B. physikalischer Effekt, auf dem das Messprinzip basiert) ab von dem Abstand des Sensors zum Stromleiter (1). In einer Ausführungsform (siehe Figur 5) ist der Hallsensor (2) für einen Messbereich von 1 A bis zu 10 kA ausgelegt, während der magnetoresistive Sensor (3) für den Messbereich von 10mA bis zu 10 A ausgelegt ist. In dem Bereich zwischen 1A und 10A überlappen sich die beiden Messbereiche. Die beiden Sensoren (2,3) erzeugen jeweils eine zum Magnetfeld und damit zum Strom proportionale Spannung, die einem Mikrokontroller als Auswerteeinheit zugeführt wird. Innerhalb des Mikrokontrollers werden die analogen Spannungswerte über Analog-/Digitalwandler (A/D-Wandler) in digitale Werte umgewandelt, um dann mittels eines Auswerteprogramms zur Berechung eines Stromwertes weiterverarbeitet zu werden. Dabei kann es vorgesehen sein, dass jedem Sensorbauelement (2, 3) eine Steuerplatine (2A, 2B) zugeordnet ist, auf der sich zur Ansteuerung und/oder Versorgung des eigentlichen Sensorbauelements weitere elektronische Bauelemente befinden. Die eigentlichen Sensorbauelemente (2, 3) können direkt auf der Steuerplatine (2A, 2B) angeordnet sein oder auch über Leitungen an diese angeschlossen sein.

Die Messbereichsumschaltung oder genauer gesagt die Auswahl des Sensors für den jeweiligen Messbereich geschieht folgendermaßen. Dem Sensor (3) zur Messung der kleinen Ströme (hier dem magnetoresistiven Sensor) ist eine obere Signalschwelle (z.B. eine Signalschwelle, die einem Strom von 10A entspricht) zugeordnet. Dem Sensor (3) zur Messung der großen Ströme (hier dem Hallsensor) ist eine untere Signalschwelle (z.B. eine Signalschwelle, die einem Strom von 1A entspricht) zugeordnet. Beide Signalwerte werden gleichzeitig der Auswerteeinheit zugeführt. Dort wird vor einer Auswertung und Umrechnung der Signale in Stromwerte überprüft, ob das Signal einer der beiden Sensoren (2, 3) seine Signalschwelle über- bzw. unterschritten hat. Es werden dann nur die Signale des Sensors berücksichtigt, dessen Signalschwelle nicht über- bzw. unterschritten wurde.

Die Auswertung und Berücksichtigung der Signalwerte im Überlappungsbereich kann unterschiedlich erfolgen, wobei der Überlappungsbereich insbesondere zur gegenseitigen Eichung der Sensoren benutzt wird. Dabei wird vorzugsweise einer der beiden Sensoren als vorab vom Werk bei Auslieferung der Einrichtung absolut geeichter Sensor eingesetzt. Dieser Sensor eicht dann nach dem Einbau der Einrichtung in das Fahrzeug den anderen Sensor. Diese Eichung erfolgt in der Auswerteeinheit (z.B. ein µC) durch Vergleich der im Messwert-Überlappungsbereich gemessenen Werte. Die Eichung kann nach dem Einbau der Einrichtung in das Fahrzeug nur einmal erfolgen oder aber auch in bestimmten Zeitabständen wiederholt werden. Darüber hinaus kann es auch vorgesehen sein, dass der vorab vom Werk geeichte Sensor nach einer bestimmten Zeitdauer seinerseits durch den anderen Sensor geeicht wird. Dies kann dann sinnvoll sein, wenn die Genauigkeit des vom Werk vorab geeichten Sensors im Laufe der Zeit stärker abnimmt als die des anderen Sensors, dessen vorab Eichung vor dem Einbau unter Umständen schwieriger ist.

Wie die Messwerte der beiden Sensoren im Überlappungsbereich bei der Berechnung des Stromwertes berücksichtigt werden kann unterschiedlich sein. In einer Auswertevariante werden im Überlappungsbereich immer nur die Messwerte eines Sensors berücksichtigt. Für diesen Zweck ist in der Auswerteeinheit eine entsprechende Information gespeichert. In einer alternativen Auswertevariante erfolgt im Überlappungsbereich eine Mittelwertbildung der beiden Messwerte. Die Auswertestrategie (Auswertealgorithmus) für die im Überlappungsbereich liegenden Messwerte ist vorgegeben und in Form eines Auswerteprogramms gespeichert.

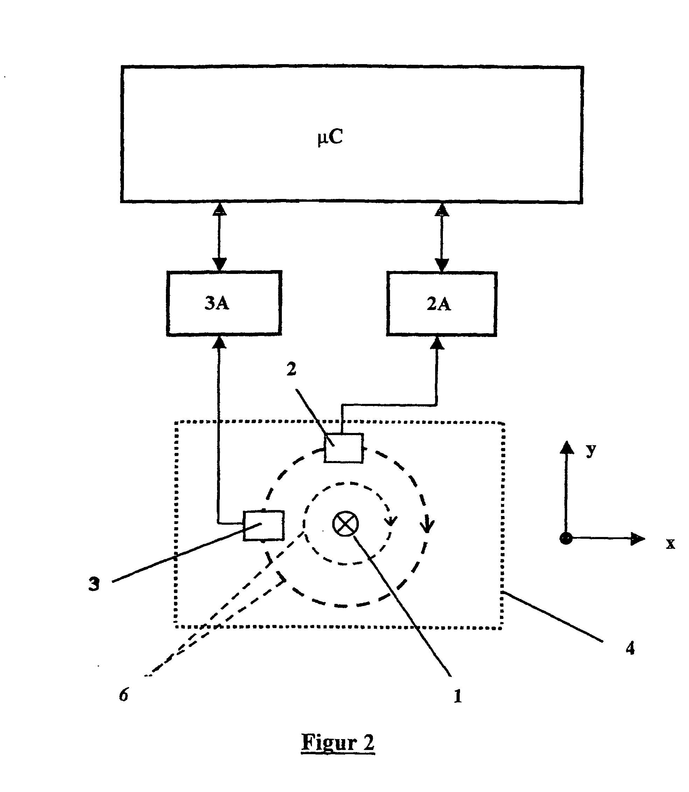

In Figur 2 ist die räumliche Anordnung der beiden Magnetfeldsensoren (2, 3) zur stromführenden Anschlussleitung (1) gezeigt. Im dargestellten Beispiel fließt der Strom in die Zeichenebene hinein. Dabei misst der Magnetfeldsensor (2) die x-Komponente des vom Strom erzeugten Magnetfeldes und der Magnetfeldsensor (3) die y-Komponente. Beide Sensoren (2, 3) sind in der Lage neben dem Betrag der Stromstärke auch dessen Richtung zu bestimmen. In einer nicht dargestellten Variante sind die beiden Magnetfeldsensoren (2, 3) so angeordnet, dass sie dieselbe Magnetfeldkomponente messen. In diesem Fall sind die beiden Sensoren bezogen auf die Zeichenebene übereinander angeordnet (d.h. in z-Richtung hintereinander). Dabei können die Sensoren fluchtend zueinander oder aber auch in radialer Richtung versetzt zueinander angeordnet sein.

Für die Offset-Kompensation und die Kompensation von ggf. Temperaturdriften des Hallsensors und des magnetoresistiven Sensors kann der Fachmann auf bekannte Verfahren und Schaltungen zurückgreifen.

Störende Fremdfelder können durch stromführende Leitungen in der Nähe der Sensoren entstehen. Bei der Messung von kleinen Strömen, z.B. im 10mA Bereich, stellt auch das Erdmagnetfeld eine nicht mehr zu vernachlässigende Störung dar. Um die Magnetfeldsensoren (2, 3) von störenden Fremdfeldern abzuschirmen, ist vorzugsweise eine die Sensoren umgebende Abschirmung (4) vorgesehen. Hierfür eignet sich z.B. ein Metallblech oder ein abschirmender Ferritkörper.

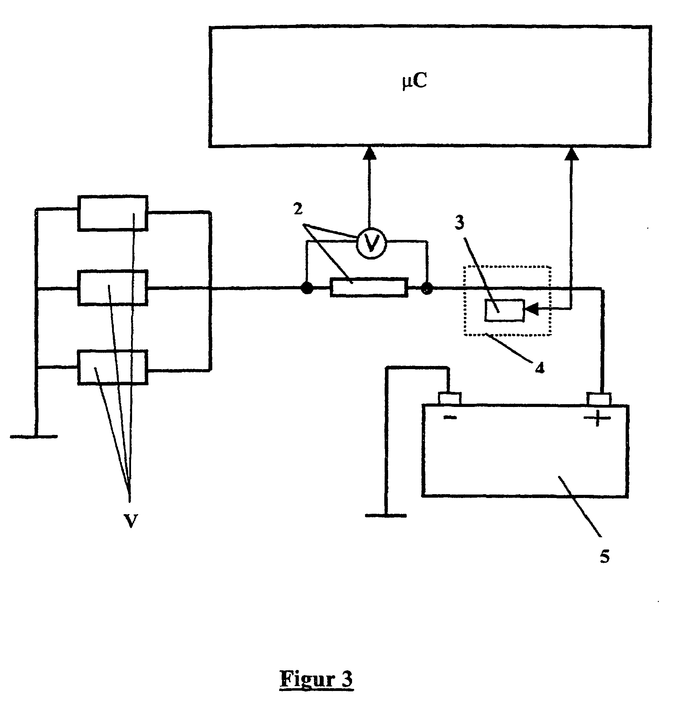

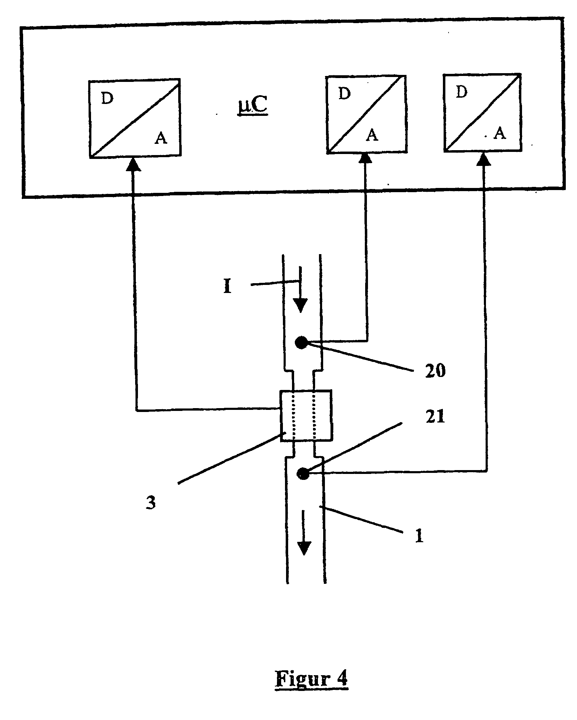

Auf den Figuren 3 und 4 ist eine zweite Ausführungsform der erfindungsgemäßen Einrichtung dargestellt. Diese Ausführungsform weist nur einen Magnetfeldsensor (3) zur potentialfreien Strommessung auf. Der andere Sensor wird von einem Messwiderstand (2) gebildet, wobei die Strommessung auf die Messung des Spannungsabfalls, den der Strom am Messwiderstand bewirkt, zurückgeführt wird. Dabei dient der Magnetfeldsensor (3) zur Messung der kleinen Ströme, während der Messwiderstand (2) zur Messung der großen Ströme dient. Auch hier kann mit dem Magnetfeldsensor (3) und dem Messwiderstand (2) gleichzeitig eine Strommessung erfolgen.

In dem in Figur 3 gezeigten Beispiel ist der Messwiderstand (2) als separates Bauteil in der stromführenden Anschlussleitung (1) angeordnet. In dem in Figur 4 gezeigten Beispiel ist der Messwiderstand (2) als Teil der stromführenden Anschlussleitung (1) ausgeführt, wobei die Spannung an zwei Punkten (20, 21) der vorzugsweise als gestanzter Metallstreifen (1) ausgebildeten Anschlussleitung abgegriffen wird.

Zur Erhöhung der Stromdichte und damit zur Konzentration der magnetischen Feldlinien weist der Metallstreifen vorzugsweise wenigstens im Bereich eines Magnetfeldsensors (2, 3) eine Einschnürung auf.

Die Magnetfeldsensoren (2, 3) können mechanisch unmittelbar oder über Abstandshalter an der Anschlussleitung (1) befestigt sein und somit auch von dieser gehalten werden.

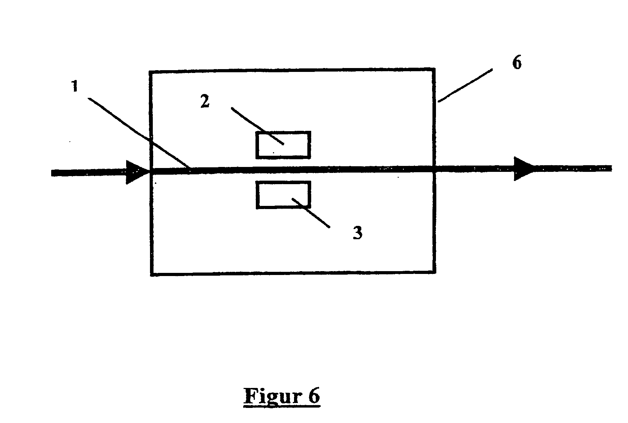

In einer Variante ist ein Sensorgehäuse (6) - siehe Figur 6 - vorgesehen, das den Anschlussleiter (1) zumindest teilweise umgibt. In diesem Sensorgehäuse (6) sind die beiden Magnetfeldsensoren (2, 3) angeordnet, wobei der Anschlussleiter (1) in dem Sensorgehäuse (6) positionsgenau zu den Sensoren (2, 3) verläuft. Das Sensorgehäuse (6) kann aus zwei zwischen sich den Anschlussleiter (1) aufnehmenden Gehäusehälften bestehen. Das Sensorgehäuse (6) seinerseits kann nun wieder mit dem Anschlussleiter (1) mechanisch verbunden und von diesem gehalten werden oder von der Fahrzeugkarosserie. In vorteilhafter Weise übernimmt das Sensorgehäuse (6) auch die Funktion der magnetischen Abschirmung.

## Patentansprüche

1. Einrichtung zur Überwachung eines Bordnetzes eines Fahrzeuges mit einem Sensor (2) zur Messung von in einer Anschlussleitung (1) fließendem elektrischen Strom,
**dadurch gekennzeichnet, dass**
- mindestens ein zweiter Sensor (3) zur Messung des Stroms in der Anschlussleitung (1) vorgesehen ist, dessen Messbereich von dem Messbereich des ersten Sensors (2) verschieden ist,
- wenigstens einer der beiden Sensoren (2,3) für eine potentialfreie Messung des Stroms ausgebildet ist.

2. Einrichtung nach Anspruch 1,
**dadurch gekennzeichnet, dass** die Einrichtung einer Anschlussleitung (1) für eine Batterie (5) zugeordnet ist.

3. Einrichtung nach Anspruch 1 oder 2,
**dadurch gekennzeichnet, dass** die beiden Sensoren (2,3) mit einer gemeinsamen Auswerteeinheit, vorzugsweise einem Mikrocontroller, verbunden sind.

4. Einrichtung nach einem der vorstehenden Ansprüche,
**dadurch gekennzeichnet, dass**
die Messbereiche der beiden Sensoren (2,3) sich in einem Teilbereich überlappen.

5. Einrichtung nach Anspruch 4,
**dadurch gekennzeichnet, dass**
im Messwert-Überlappungsbereich von beiden Sensoren (2,3) Messwerte aufgenommen werden, wobei anhand der Messwerte des ersten Sensors (2) eine Eichung des zweiten Sensors (3) durchgeführt wird oder umgekehrt.

6. Einrichtung nach Anspruch 5,
**dadurch gekennzeichnet, dass**
zumindest einer der beiden Sensoren (2, 3) als absolut geeichter Sensor (2, 3) ausgebildet ist.

7. Einrichtung nach einem der vorstehenden Ansprüche,
**dadurch gekennzeichnet, dass**
mindestens einer der beiden Sensoren (2,3). ein Magnetfeldsensor ist, der zur potentialfreien Messung des Stroms in der Anschlussleitung (1) das vom Strom erzeugte Magnetfeld misst.

8. Einrichtung nach Anspruch 7,
**dadurch gekennzeichnet, dass** beide Sensoren Magnetfeldsensoren sind, und daß
die beiden Magnetfeldsensoren (2, 3) so angeordnet sind, dass sie unterschiedliche Komponenten des vom Strom erzeugten Magnetfeldes messen.

9. Einrichtung nach Anspruch 7,
**dadurch gekennzeichnet, dass**
die beiden Magnetfeldsensoren (2, 3) so angeordnet sind, dass sie dieselbe Komponente des vom Strom erzeugten Magnetfeldes messen.

10. Einrichtung nach einem der Ansprüche 7 bis 9,
**dadurch gekennzeichnet, dass**
der Magnetfeldsensor (2) ein Hallsensor ist.

11. Einrichtung nach einem der Ansprüche 7 bis 10,
**dadurch gekennzeichnet, dass**
der Magnetfeldsensor (3) ein magnetoresistiver Sensor ist.

12. Einrichtung nach einem der Ansprüche 7 bis 10,
**dadurch gekennzeichnet, dass**
zur Messung von großen Strömen ein Hallsensor (2) vorgesehen ist, und zur Messung von kleinen Strömen ein magnetoresistiver Sensor (3) vorgesehen ist.

13. Einrichtung nach einem der Ansprüche 7 und 11,
**dadurch gekennzeichnet, dass**
zur Messung von kleinen Strömen ein Magnetfeldsensor (2) vorgesehen ist, und zur Messung von großen Strömen ein Widerstand in der Anschlussleitung (1) als Sensor (2) vorgesehen ist, wobei der Spannungsabfall, den der Strom in der Anschlussleitung (1) an dem Widerstand hervorruft, als Stromsignal gemessen wird.

14. Einrichtung nach Anspruch 13,
**dadurch gekennzeichnet, dass**
ein Teil der Anschlussleitung (1) selbst als Messwiderstand verwendet wird.

15. Einrichtung nach einem der Ansprüche 7 bis 14,
**dadurch gekennzeichnet, dass**
wenigstens einer der Magnetfeldsensoren (2,3) von einer Abschirmung gegen magnetische Fremdfelder umgeben ist.

16. Einrichtung nach einem der vorstehenden Ansprüche,
**dadurch gekennzeichnet, dass**
die Anschlussleitung (1) als gestanzter Metallstreifen ausgebildet ist.

17. Einrichtung nach einem der vorstehenden Ansprüche,
**dadurch gekennzeichnet, dass**
die Anschlussleitung (1) wenigstens im Bereich eines Magnetfeldsensors (2,3) eine Einschnürung zur Erhöhung der Stromdichte und damit zur Konzentration der magnetischen Feldlinien aufweist.

18. Einrichtung nach einem der Ansprüche 7 bis 17,
**dadurch gekennzeichnet, dass**
mindestens einer der Magnetfeldsensoren (2, 3) mechanisch an der Anschlussleitung (1) befestigt ist.

19. Einrichtung nach einem der Ansprüche 7 bis 18,
**gekennzeichnet durch**,
ein den Anschlussleiter (1) zumindest teilweise umgebendes Sensorgehäuse (6), in dem die beiden Sensoren (2, 3) angeordnet sind, wobei der Anschlussleiter (1) in dem Gehäuse (6) positionsgenau zu dem/den Magnetfeldsensor(en) verläuft.

20. Einrichtung nach Anspruch 19,
**dadurch gekennzeichnet, dass**
das Sensorgehäuse (6) aus zwei zwischen sich den Anschlussleiter (1) aufnehmenden Gehäusehälften besteht.

21. Einrichtung nach Anspruch 19 oder 20,
**dadurch gekennzeichnet, dass**
das Sensorgehäuse (6) mit dem Anschlussleiter (1) mechanisch verbunden und von diesem gehalten ist.

22. Einrichtung nach Anspruch 19 oder 20,
**dadurch gekennzeichnet, dass**
das Sensorgehäuse (6) mit der Karosserie des Fahrzeuges mechanisch verbunden und von dieser gehalten ist.

## Claims

1. Device for monitoring a vehicle power supply network with a sensor (2) for measuring electrical current in a connecting lead (1),
**characterised by** the fact that
- at least a second sensor (3) is provided for measuring current in the connecting lead (1), the measuring area of which is different from the measuring area of the first sensor (2),
- at least one of the two sensors (2, 3) is made for floating measurement of the current.

2. Device according to claim 1,
**characterised by** the fact that the device is assigned to a connecting lead (1) for a battery (5).

3. Device according to claim 1 or 2,
**characterised by** the fact that both sensors (2, 3) are connected to a joint evaluation unit, preferably a micro controller.

4. Device according to one of the previous claims,
**characterised by** the fact that
the measuring areas of both sensors (2, 3) overlap in part.

5. Device according to claim 4,
**characterised by** the fact that
measured values are recorded in the measured value overlap area of both sensors (2, 3), in which the second sensor (3) is calibrated using the measured values of the first sensor (2) or vice versa.

6. Device according to claim 5,
**characterised by** the fact that
at least one of the two sensors (2, 3) is made as an absolutely calibrated sensor (2, 3).

7. Device according to one of the previous claims,
**characterised by** the fact that
at least one of the two sensors (2, 3) is a magnetic field sensor, which measures the current created by the magnetic field for floating measurement of the current in the connecting lead (1).

8. Device according to claim 7,
**characterised by** the fact that both sensors are magnetic field sensors and that both magnetic field sensors (2, 3) are arranged so that they measure different components of the magnetic field produced by the current.

9. Device according to claim 7,
**characterised by** the fact that
both magnetic field sensors (2, 3) are arranged so that they measure the same components of the magnetic field produced by the current.

10. Device according to one of claims 7 to 9,
**characterised by** the fact that
the magnetic field sensor (2) is a Hall effect sensor.

11. Device according to claims 7 to 10,
**characterised by** the fact that
the magnetic field sensor (2) is a magneto resistive sensor.

12. Device according to one of claims 7 to 10,
**characterised by** the fact that
a Hall effect sensor (2) is provided for measuring large currents and a magneto resistive sensor (3) is provided for measuring small currents.

13. Device according to one of claims 7 and 11,
**characterised by** the fact that a magnetic field sensor (2) is provided for measuring small currents and a resistor is provided as a sensor (2) in the connecting lead (1) for measuring large currents, in which the voltage drop, which the current causes in the connecting lead (1) to the resistor, is measured as a current signal.

14. Device according to claim 13,
**characterised by** the fact that
part of the connecting lead (1) itself is used as a measuring resistor.

15. Device according to one of claims 7 to 14,
**characterised by** the fact that
at least one of the magnetic field sensors (2, 3) is surrounded by a shield against interfering magnetic fields.

16. Device according to one of the previous claims,
**characterised by** the fact that
the connecting lead (1) is made as blanked metal strips.

17. Device according to one of the previous claims,
**characterised by** the fact that
at least in the area of one magnetic field sensor (2, 3) the connecting lead (1) has a constriction to increase the current density and therefore the concentration of the magnetic field lines.

18. Device according to claims 7 to 17,
**characterised by** the fact that
at least one of the magnetic field sensors (2, 3) is fastened mechanically to the connecting lead (1).

19. Device according to one of claims 7 to 18,
**characterised by**
a sensor housing (6) at least partly surrounding the connecting lead (1), in which both sensors (2, 3) are arranged, in which the connecting lead (1) runs in a precise position to the magnetic field sensor(s) in the housing (6).

20. Device according to claim 19,
**characterised by** the fact that
the sensor housing (6) consists of two halves incorporating the connecting lead (1) between them.

21. Device according to claim 19 or 20,
**characterised by** the fact that
the sensor housing (6) is mechanically connected to the connecting lead (1) and held by it.

22. Device according to claim 19 or 20,
**characterised by** the fact that
the sensor housing (6) is mechanically connected to the bodywork of the vehicle and held by it.

## Revendications

1. Système de surveillance d'un réseau de bord d'un véhicule, comportant un capteur (2) pour mesurer le courant électrique s'écoulant dans une ligne de connexion (1),
**caractérisé en ce que**
- il est prévu au moins un deuxième capteur (3) pour mesurer le courant dans la ligne de connexion (1), dont la plage de mesure diffère de la plage de mesure du premier capteur (2),
- au moins un des deux capteurs (2, 3) est réalisé pour la mesure du courant indépendamment du potentiel.

2. Système selon la revendication 1, **caractérisé en ce que** le système est associé à une ligne de connexion (1) pour une batterie (5).

3. Système selon l'une ou l'autre des revendications 1 et 2, **caractérisé en ce que** les deux capteurs (2, 3) sont reliés à une unité d'évaluation commune, de préférence à un microcontrôleur.

4. Système selon l'une des revendications précédentes, **caractérisé en ce que** les plages de mesure des deux capteurs (2, 3) se chevauchent dans une plage partielle.

5. Système selon la revendication 4, **caractérisé en ce que** dans la plage de chevauchement de valeurs de mesure des deux capteurs (2, 3) sont enregistrées des valeurs de mesure, et à l'aide des valeurs mesurées du premier capteur (2) est effectué un calibrage du deuxième capteur (3) ou inversement.

6. Système selon la revendication 5, **caractérisé en ce qu'**au moins un des deux capteurs (2, 3) est réalisé en tant que capteur calibré de manière absolue.

7. Système selon l'une des revendications précédentes, **caractérisé en ce qu'**au moins un des deux capteurs (2, 3) est un capteur de champ magnétique qui mesure le champ magnétique engendré par le courant pour mesurer le courant dans la ligne de connexion (1) indépendamment du potentiel.

8. Système selon la revendication 7, **caractérisé en ce que** les deux capteurs sont des capteurs de champ magnétique et **en ce que** les deux capteurs de champ magnétique (2, 3) sont agencés de telle sorte qu'ils mesurent différentes composantes du champ magnétique engendré par le courant.

9. Système selon la revendication 7, **caractérisé en ce que** les deux capteurs de champ magnétique (2, 3) sont agencés de telle sorte qu'ils mesurent la même composante du champ magnétique engendré par le courant.

10. Système selon l'une des revendications 7 à 9, **caractérisé en ce que** le capteur de champ magnétique (2) est un capteur de Hall.

11. Système selon l'une des revendications 7 à 10, **caractérisé en ce que** le capteur de champ magnétique (2) est un capteur magnétorésistif.

12. Système selon l'une des revendications 7 à 10, **caractérisé en ce qu'**il est prévu un capteur de Hall (2) pour mesurer des grands courants et un capteur magnétorésistif (3) pour mesurer des petits courants.

13. Système selon l'une ou l'autre des revendications 7 et 11, **caractérisé en ce que** pour mesurer des petits courants, il est prévu un capteur de champ magnétique (2) et pour mesurer des grands courants, il est prévu à titre de capteur (2) une résistance dans la ligne de connexion (1), la chute de tension, que le courant dans la ligne de connexion (1) provoque aux bornes de la résistance, est mesurée en tant que signal de courant.

14. Système selon la revendication 13, **caractérisé en ce qu'**une partie de la ligne de connexion (1) est elle-même utilisée en tant que résistance de mesure.

15. Système selon l'une des revendications 7 à 14, **caractérisé en ce qu'**au moins un des capteurs de champ magnétique (2, 3) est entouré d'un blindage vis-à-vis de champs magnétiques parasites.

16. Système selon l'une des revendications précédentes, **caractérisé en ce que** la ligne de connexion (1) est réalisée sous forme de bande métallique estampée.

17. Système selon l'une des revendications précédentes, **caractérisé en ce que** la ligne de connexion (1) présente au moins dans la région d'un capteur de champ magnétique (2, 3) un étranglement pour augmenter la densité de courant et par conséquent pour concentrer les lignes de champ magnétique.

18. Système selon l'une des revendications 7 à 17, **caractérisé en ce qu'**au moins un des capteurs de champ magnétique (2, 3) est fixé par la voie mécanique à la ligne de connexion (1).

19. Système selon l'une des revendications 7 à 18, **caractérisé par** un boîtier de capteur (6) dans lequel sont agencés les deux capteurs (2, 3), entoure au moins partiellement la ligne de connexion (1), la ligne de connexion (1) s'étendant dans le boîtier (6) en position exacte par rapport au/aux capteur(s) de champ magnétique.

20. Système selon la revendication 19, **caractérisé en ce que** le boîtier de capteur (6) est constitué par deux moitiés de boîtier recevant entre elles la ligne de connexion (1).

21. Système selon l'une ou l'autre des revendications 19 et 20, **caractérisé en ce que** le boîtier de capteur (6) est relié mécaniquement à la ligne de connexion (1) et est retenu par celle-ci.

22. Système selon l'une ou l'autre des revendications 19 et 20, **caractérisé en ce que** le boîtier de capteur (6) est relié mécaniquement à la carrosserie du véhicule et est retenu par celle-ci.
